(19)

Europäisches
Patentamt
European
Patent Office
Office européen
des brevets

(11) **EP 4 583 245 A2**

(12) **EUROPEAN PATENT APPLICATION**

(43) Date of publication:
**09.07.2025 Bulletin 2025/28**

(21) Application number: **25177347.9**

(22) Date of filing: **01.03.2022**

(51) International Patent Classification (IPC):
**H01M 10/48** (2006.01)

(52) Cooperative Patent Classification (CPC):
**H02J 7/005; G01R 31/36; G01R 31/3648;
G01R 31/367; G01R 31/382; G01R 31/389;
G01R 31/392; H01M 10/48; H01M 10/486;
H02J 7/00711; H02J 7/007182;** Y02E 60/10

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **12.05.2021 JP 2021080843**

(62) Document number(s) of the earlier application(s) in
accordance with Art. 76 EPC:
**22807098.3 / 4 318 862**

(71) Applicant: **Toyo System Co., Ltd.
Iwaki-shi, Fukushima 972-8316 (JP)**

(72) Inventors:
• **Munakata, Ichiro**
**Iwaki-shi, Fukushima, 972-8316 (JP)**

• **Igari, Shuntaro**
**Iwaki-shi, Fukushima, 972-8316 (JP)**
• **Tanno, Satoshi**
**Iwaki-shi, Fukushima, 972-8316 (JP)**
• **Shoji, Hideki**
**Iwaki-shi, Fukushima, 972-8316 (JP)**

(74) Representative: **Schön, Christoph
Dr. Schön, Neymeyr & Partner mbB
Bavariaring 26
80336 München (DE)**

Remarks:
This application was filed on 19-05-2025 as a
divisional application to the application mentioned
under INID code 62.

(54) **BATTERY PERFORMANCE EVALUATION DEVICE AND BATTERY PERFORMANCE
EVALUATION METHOD**

(57) Provided are a device and the like capable of evaluating the performance of a secondary battery while reducing the arithmetic processing load required for identifying the values of model parameters defining a model used for evaluating the performance of the secondary battery. According to whether a designated condition is satisfied or not, a different battery model is determined as a battery model used for evaluating the performance of a target secondary battery. Specifically, when a designated condition is satisfied, a second battery model is determined which is defined by a smaller number of second model parameters than a plurality of first model parameters and is therefore a simpler battery model than a first battery model defined by the plurality of first model parameters (which is a battery model determined in the case where a designated condition is not satisfied).

FIG.2

EP 4 583 245 A2

## Description

Technical Field

The present invention relates to a system and the like for determining the deterioration state of a secondary battery such as a lithium-ion battery.

Background Art

The present applicant has proposed a technical method that makes it possible to determine the deterioration state of a target secondary battery even when no initial measurement result of the characteristic paramete33rs of the secondary battery itself is available (refer to Patent Literature 1). To be specific, based on a present measurement value V (k) of a voltage V of a secondary battery and a present measurement value I (k) of a current I, a past value of the voltage V is specified as an initial characteristic estimated value V (0←k) according to a multivariable function G that represents an initial characteristic model. The "initial characteristic model" is a model representing the initial characteristics of a reference secondary battery of the same standard as the secondary battery to be subjected to deterioration state determination.

The present applicant has proposed a technical method for evaluating the battery performance of a secondary battery by using a secondary battery model in which the impedance of the internal resistance of the secondary battery is expressed by impulse responses representing each of an IIR system and a FIR system (refer to Patent Literature 2).

Citation List

Patent Literatures

    Patent Literature 1: Japanese Patent No. 6745554
    Patent Literature 2: Japanese Patent No. 6842212

Summary of Invention

Technical Problem

However, when there are many model parameters that define a model, there are cases where an arithmetic processing load required for identifying the values of the model parameters becomes excessive. For this reason, there has been a possibility that the scope of application will be inconveniently limited, typically represented by an example in which it becomes difficult to perform, in a device, the on-board battery performance evaluation processing for a secondary battery installed in the device.

Therefore, an object of the present invention is to provide a device and the like that make it possible to evaluate the performance of a secondary battery while reducing an arithmetic processing load required for identifying the values of model parameters that define a model used for evaluating the performance of the secondary battery.

Solution to Problem

A battery performance evaluation device according to the present invention includes:

    a first recognition processing element that recognizes a measurement result of an impedance of a reference secondary battery;
    a first arithmetic processing element that identifies, on the basis of a measurement result of the impedance of the reference secondary battery recognized by the first recognition processing element, a value of each of a plurality of first model parameters thereby to determine a first battery model defined by the plurality of first model parameters in the case where a designated condition is not satisfied, and identifies a value of each of a plurality of second model parameters that are fewer than the plurality of first model parameters thereby to determine a second battery model defined by the plurality of second model parameters in the case where the designated condition is satisfied;
    a second recognition processing element that recognizes an actually measured output voltage as a measurement result of a change form of a voltage output from a target secondary battery, which has the same characteristics as those of the reference secondary battery, at the time of input of a designated current to the target secondary battery;

a second arithmetic processing element that specifies a model output voltage as a change form of a voltage output from the first battery model or the second battery model at the time of input of the designated current to the first battery model or the second battery model determined by the first arithmetic processing element; and

a battery performance evaluation element that evaluates performance of the target secondary battery on the basis of a result of comparison between the actually measured output voltage recognized by the second recognition processing element and the model output voltage specified by the second arithmetic processing element.

The battery performance evaluation device in accordance with the present invention determines different battery models as battery models used for evaluating the performance of a target secondary battery depending on whether a designated condition is satisfied or not. To be specific, when a designated condition is satisfied, then the second battery model is determined, which is defined by a plurality of second model parameters that are fewer than a plurality of first model parameters, and is therefore a simpler battery model than the first battery model defined by the plurality of first model parameters (the battery model determined when the designated condition is not satisfied). Consequently, the arithmetic processing load required for identifying the model parameters of a battery model used for evaluating the performance of a target secondary battery is reduced, as compared with the case where the first battery model is established regardless of whether a designated condition is satisfied.

Brief Description of Drawings

FIG. 1 is an explanatory diagram related to the configuration of a battery performance evaluation device as an embodiment of the present invention.

FIG. 2 is a flowchart illustrating the procedure of a battery performance evaluation method for a target secondary battery.

FIG. 3A is an explanatory diagram related to a first battery model (full model).

FIG. 3B is an explanatory diagram related to a second battery model (simplified model).

FIG. 4A is an explanatory diagram related to a Nyquist plot using a full model of a secondary battery.

FIG. 4B is an explanatory diagram related to a Nyquist plot using a simplified model of a secondary battery.

FIG. 5A is an explanatory diagram related to a designated current.

FIG. 5B is an explanatory diagram related to the voltage response characteristics of a secondary battery and a battery model.

Description of Embodiments

(Configuration of the battery performance evaluation device)

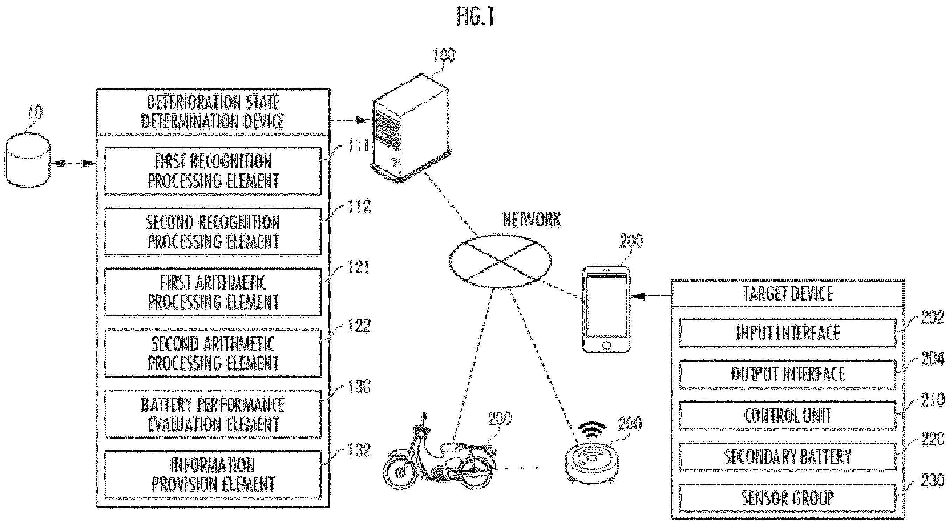

A battery performance evaluation device 100 as an embodiment of the present invention illustrated in FIG. 1 is composed of one or a plurality of servers capable of communicating with each of a database 10 and a target device 200 via a network. The battery performance evaluation device 100 evaluates the performance of a secondary battery 220 installed as a power source in the target device 200.

The battery performance evaluation device 100 includes a first recognition processing element 111, a second recognition processing element 112, a first arithmetic processing element 121, a second arithmetic processing element 122, a battery performance evaluation element 130, and an information provision element 132. Each of the first recognition processing element 111, the second recognition processing element 112, the first arithmetic processing element 121, the second arithmetic processing element 122, the battery performance evaluation element 130, and the information provision element 132 is composed of a processor (arithmetic processing device), a memory (storage device), an I/O circuit, and the like. The memory or a storage device that is separate therefrom stores and holds various data such as measurement results of the voltage response characteristics of the secondary battery 220 with respect to a designated current, as well as programs (software). For example, each of a plurality of identifiers for distinguishing the type of the secondary battery 220 or the target device 200 provided with the secondary battery 220 (specified by standards and characteristics) is associated with each of a plurality of secondary battery models, and stored and held in the memory.

A processor reads necessary programs and data from a memory, and based on the data, performs arithmetic processing according to the programs thereby to perform arithmetic processing or tasks, which will be described later, assigned to the elements 111, 112, 121, 122, 130 and 132. The phrase of each element "recognizing" information means that each element performs any arithmetic processing for preparing information or data required for subsequent arithmetic processing, such as receiving information, retrieving or reading information from an information source such as the database 10, and performing arithmetic processing on basic information thereby to calculate, estimate, specify, identify, or predict information.

The target device 200 includes an input interface 202, an output interface 204, a control unit 210, the secondary battery 220, and a sensor group 230. The target device 200 includes any device such as a personal computer, a mobile phone (smartphone), a home appliance, and a moving vehicle such as an electric bicycle, which use the secondary battery 220 as the power source thereof.

The control unit 210 is composed of a processor (arithmetic processing unit), a memory (storage device), an I/O circuit, and the like. The memory or a storage device that is separate therefrom stores and holds various data such as measurement results of the voltage response characteristics of the secondary battery 220. The control unit 210 operates in response to power supplied from the secondary battery 220 to control the operation of the target device 200 in an energized state. The operation of the target device 200 includes the operation of an actuator (electric actuator or the like) constituting the target device 200. The processor constituting the control unit 210 reads necessary programs and data from the memory, and performs assigned arithmetic processing on the basis of the data according to the programs.

The secondary battery 220 is, for example, a lithium-ion battery, and may be any other secondary battery such as a nickel-cadmium battery. The sensor group 230 measures the values of parameters required for controlling the target device 200, as well as the voltage response characteristics and the temperature of the secondary battery 220. The sensor group 230 is composed of, for example, a voltage sensor, a current sensor, and a temperature sensor, which output signals corresponding to the voltage, the current, and the temperature, respectively, of the secondary battery 220.

The battery performance evaluation device 100 may be installed in the target device 200. In this case, a software server (not illustrated) may transmit deterioration determination software to an arithmetic processing unit that constitutes the control unit 210 installed in the target device 200 so as to impart the function as the battery performance evaluation device 100 to the arithmetic processing unit.

(Battery performance evaluation method)

A description to be given later will explain the battery performance evaluation method of the secondary battery 220 (the target secondary battery) performed by the battery performance evaluation device 100 having the above-described configuration.

(Recognizing impedance measurement results)

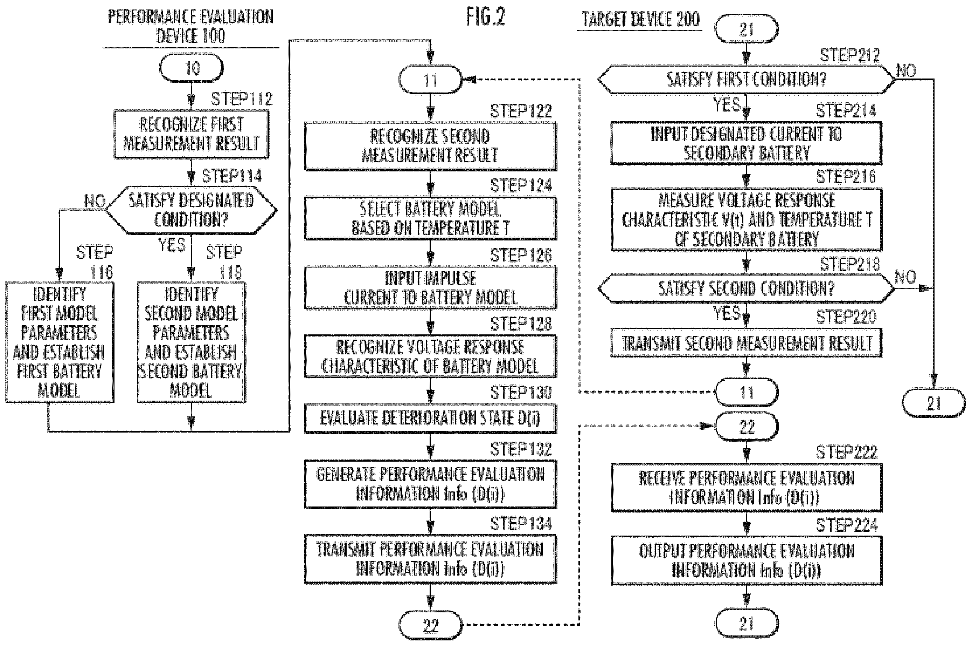

The first recognition processing element 111 in the battery performance evaluation device 100 recognizes the measurement results of the impedance, such as complex impedance Z, of the secondary battery 220 as various types of reference secondary batteries (STEP112 of FIG. 2). The complex impedance Z of a reference secondary battery is measured according to an AC impedance method, and the measurement result is associated with an identifier for distinguishing the type of the reference secondary battery, and registered in the database 10.

The complex impedance Z of the secondary battery 220 as a reference secondary battery in a state of not being installed in the target device 200 is measured. Alternatively, the complex impedance Z of the secondary battery 220 as a reference secondary battery in a state of being installed in the target device 200 may be measured. For example, the target device 200 can be connected to a power source, such as a commercial power source, for charging the secondary battery 220, and sinusoidal signals can be output by the power supplied from the power source.

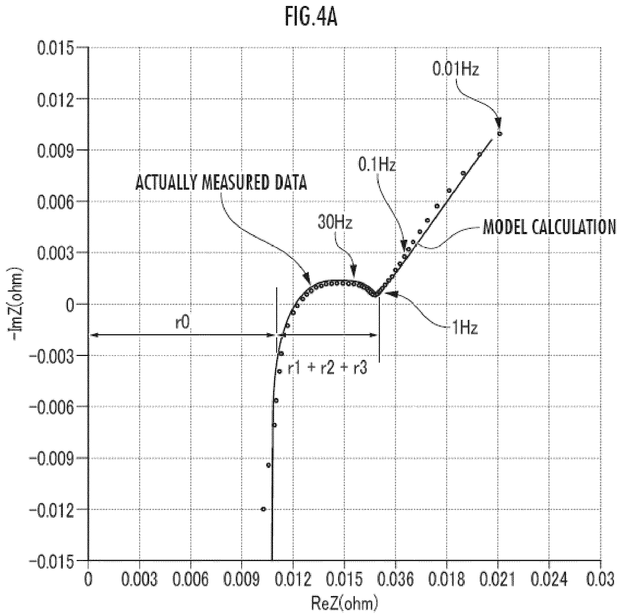

FIG. 4A illustrates an example of a Nyquist plot indicating the actually measured results of the complex impedance Z of the secondary battery 220, together with an approximate curve of the plot. The horizontal axis denotes a real part ReZ of the complex impedance Z, and the vertical axis denotes an imaginary part -ImZ of the complex impedance Z. In a region of -ImZ > 0, the complex impedance Z at lower frequencies is shown as ReZ increases. The value of ReZ at -ImZ = 0 corresponds to a transfer resistance in the electrolyte of the secondary battery 220. The radius of curvature of the substantially semicircular portion in the region of -ImZ > 0 corresponds to the charge transfer resistance of the secondary battery 220. The radius of curvature tends to decrease as a temperature T of the secondary battery 220 increases. The influence of the Warburg impedance of the secondary battery 220 is reflected in the linear portion that rises at approximately 45° in the low frequency region of -ImZ > 0.

(Establishing secondary battery models)

In the battery performance evaluation device 100, the first arithmetic processing element 121 determines whether a designated condition is satisfied (STEP114 of FIG. 2). The designated condition is, for example, a condition that the designated current applied to the secondary battery 220 as a target second battery is composed of a low frequency current component that is lower than a sampling frequency. For example, in the Nyquist plot illustrated in FIG. 4A, the frequency (~ 1 Hz) corresponding to the place where the linear rise of approximately 45° in the low frequency region of the region of -ImZ > 0 may be adopted as the sampling frequency. For example, a current composed of a low frequency current component corresponding to a charge/discharge current of the secondary battery 220 corresponds to the designated current.

In addition to or in place of the above-described condition, a condition or conditions defined as a designated condition or conditions may include a condition that the arithmetic processing load (CPU usage rate or the like) of the first arithmetic processing element 121 is a reference value or more, a condition that the target device 200 is a device in which the required accuracy or urgency of the performance evaluation of the secondary battery 220 is a threshold value or less (e.g., a device in which the degree of functional deterioration attributable to the performance deterioration of the secondary battery 220 is low, such as a smartphone and a personal computer), and/or a condition that the period of time elapsed from the point of time of the previous performance evaluation of the secondary battery 220 to be subjected to a present performance evaluation is less than a designated period of time.

When it is determined that a designated condition is not satisfied (NO in STEP114 of FIG. 2), then based on the measurement results of the complex impedance Z of the secondary battery 220 as the reference secondary battery recognized by the first recognition processing element 111, the values of the plurality of first model parameters defining the first battery model are identified for each different temperature (STEP116 of FIG. 2).

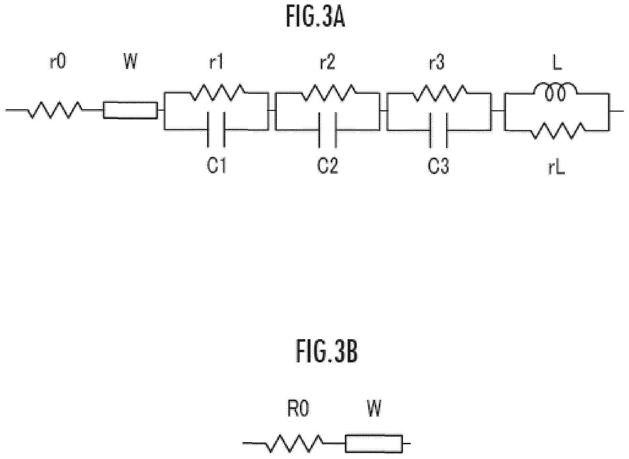

The first battery model is a model that represents a voltage V (z) output from the secondary battery 220 when a current I (z) is input to the secondary battery 220. The first battery model (full model) is defined by, for example, an equivalent circuit in which a resistance $r_0$ corresponding to the transfer resistance in the electrolyte, a Warburg impedance W, an i-th RC parallel circuit (i = 1, 2, .., m) composed of a resistance $r_i$ corresponding to a charge transfer resistance and a capacitor $C_i$, and an LR parallel circuit composed of a coil L and a resistance $r_L$ are connected in series, as illustrated in FIG. 3A.

The number of the RC parallel circuits to be connected in series may be less than three, or more than three. The Warburg impedance W may be connected with a resistance R in series in at least one RC parallel circuit. The capacitor C may be replaced by a CPE (Constant Phase Element).

The first battery model is defined by a relational expression (11) using an open-circuit voltage OCV (z) and an internal resistance transfer function $H_I$ (z) of the secondary battery 220.

$$V (z) = OCV (z) + H_1 (z) \cdot I (z) \quad .. (11)$$

Here, OCV (z) indicates that the open-circuit voltage increases or decreases according to the charging and/or discharging of the current I (z).

The internal resistance transfer function $H_I$ (z) in the first battery model is defined by a relational expression (16) using a transfer function $H_0$ (z) of the resistance $r_0$ defined by a relational expression (12), the transfer function Hi (z) in the i-th RC parallel circuit defined by a relational expression (13), a transfer function $H_w$ (z) of the Warburg impedance W defined by a relational expression (14), and a transfer function $H_L$ (z) of the LR parallel circuit defined by a relational expression (15).

$$H_0 (z) = r_0 \quad .. \quad (12)$$

$$H_i (z) = (b_{i0} + b_{il}z^{-1}) / (1 + a_{il}z^{-1}) \quad .. \quad (13)$$

Here, $a_i$, $b_{i0}$, and $b_{il}$ are represented by coefficient relational expressions (131) and (132) using a sampling cycle T.

$$a_i = - (T - 2r_iC_i) / (T + r_iC_i) \quad .. \quad (131)$$

$$b_{i0} = b_{il} = r_iT / (T + r_iC_i) \quad .. \quad (132)$$

The transfer function $h_w$ (s) of the Warburg impedance W that matches the experiment data is represented by a relational expression (141) or (142) in a frequency domain.

$$h_w (s) = w_l \cdot \tanh \{(sw_2)^{w3}\} / (sw_2)^{w3} \quad .. \quad (141)$$

$$h_w (s) = w_l \cdot \coth \{(sw_2)^{w3}\} / (sw_2)^{w3} \quad .. \quad (142)$$

In order to correspond to an impulse response, the transfer function is expanded to FIR and represented by relational expressions (14) to (16).

$$\text{Hw}(z) = \Sigma^n_{k=0} h_k z^{-k} \quad .. \quad (14)$$

$$H_L(z) = (2L_0 / T)(1 - z^{-1}) / (1 + z^{-1}) \quad .. \quad (15)$$

$$H_1(z) = H_L(z) + \Sigma^m_{i=1} H_i(z) + H_w(z) + H_0(z) \quad .. \quad (16)$$

The approximate curve of the complex impedance Z of the secondary battery represented by the Nyquist plot indicated by the solid line in FIG. 4A is obtained under an assumption that the transfer function H (z) of the equivalent circuit model of the internal resistance of the secondary battery is defined according to the relational expression (16). Thus, the values of the first model parameters $r_0$, $r_i$, $C_i$, $w_1$, $w_2$, $w_3$, $r_L$ and L are determined (refer to the relational expressions (12) to (15)). Table 1 shows an example of the identification results of the values of the first model parameters and time constants.

[Table 1]

| Parameter | Value | Time constant |
|---|---|---|
| $r_0$ | 0.0103 Ω | |
| $r_1$ | 0.00207 Ω | 5.71 ms |
| C1 | 2.76 F | |
| $r_2$ | 0.00241 Ω | 0.718 ms |
| C2 | 0.298 F | |
| $r_3$ | 0.00172 Ω | 0.0687 ms |
| C3 | 0.0687 F | |
| $W_R$ | 0.0516 Ω | |
| $W_T$ | 164.4 | |
| $W_P$ | 0.6065 | |
| $L_1$ | 0.515 μH | ≤ 1 ms |
| $r_L$ | 1.19 Ω | |

The value of the open-circuit voltage OCV in the secondary battery model is identified by the measurement value of the open-circuit voltage OCV (refer to the relational expression (11)). Then, based on the values of the parameters, the first battery model is established as the secondary battery 220 as the reference secondary battery of various characteristics or specifications.

On the other hand, when it is determined that the designated condition is satisfied (YES in STEP114 of FIG. 2), then based on the measurement results of the complex impedance Z of the secondary battery 220 as the reference secondary battery recognized by the first recognition processing element 111, the values of the plurality of second model parameters defining the second battery model are identified for each different temperature (STEP118 of FIG. 2).

As with the first battery model, the second battery model is a model that represents the voltage V (z) output from the secondary battery 220 when the current I (z) is input to the secondary battery 220. The second battery model is a simplified model, as compared with the first battery model, in the case where the time constant of the transfer function $H_i(z)$ of the i-th RC parallel circuit defined by the relational expression (13) is sufficiently smaller than the sampling cycle T. For example, the second battery model is defined by the equivalent circuit in which a single resistance $R_0$ and a single Warburg impedance W are connected in series, as illustrated in FIG. 3B.

The second battery model is defined by a relational expression (21) using the open-circuit voltage OCV (z) and the transfer function $H_2(z)$ of the internal resistance of the secondary battery 220.

$$V(z) = OCV(z) + H_2(z) \cdot I(z) \quad .. \quad (21)$$

The transfer function $H_1(z)$ of the internal resistance in the second battery model is defined by a relational expression (26) using the transfer function $H_0$ (z) of the resistance $R_0$ defined by a relational expression (22) and the transfer function $H_w$ (z) of the Warburg impedance W defined by the relational expression (14). The resistance $R_0$ is regarded as a single resistance as an aggregated result of the resistance $r_0$ corresponding to the transfer resistance in the electrolyte and a resistance $r_i$ (i = 1, 2, .., m) corresponding to the charge transfer resistance.

$$H_0\,(z) = R_0 = r_0 + \Sigma^m_{i=1}\,r_i \quad .. \quad (22)$$

$$H_2\,(z) = H_w\,(z) + H_0\,(z) \qquad .. \quad (26)$$

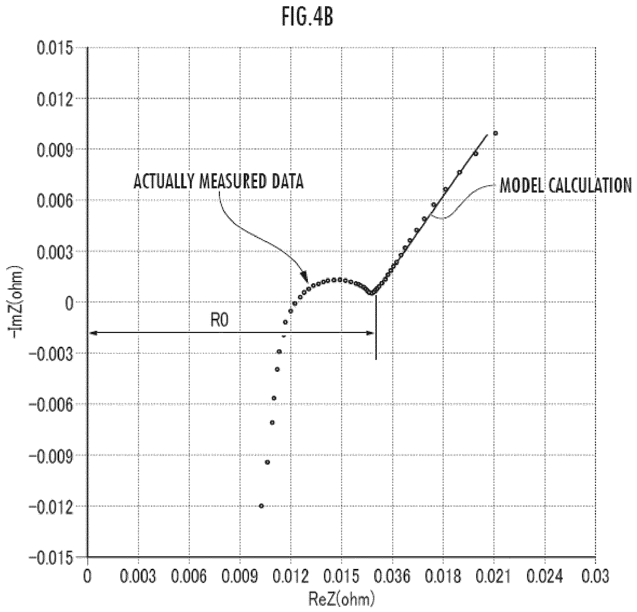

The approximate curve (especially the linear portion in the region of -ImZ > 0) of the complex impedance Z of the secondary battery represented by the Nyquist plot indicated by the solid line in FIG. 4B is obtained under an assumption that the transfer function H (z) of the equivalent circuit model of the internal resistance of the secondary battery is defined according to the relational expression (26). Consequently, the values of the second model parameters $r_0$, $r_i$, $w_1$, $w_2$, and $w_3$ are obtained (refer to the relational expressions (22) and (14)). The value of the open-circuit voltage OCV in the secondary battery model is identified on the basis of the measurement value of the open-circuit voltage OCV (refer to the relational expression (21)). Then, based on the values of the parameters, the second battery model is established as the secondary battery 220 serving as the reference secondary battery of various characteristics or specifications.

The number of the second model parameters ($R_0$, $w_1$, $w_2$, and $w_3$) is four, which is smaller than the number "12" of the first model parameters ($r_0$, $r_i$ (i = 1 to 3), $C_i$ (i = 1 to 3), $w_1$, $w_2$, $w_3$, $r_L$, and L). Further, some of the second model parameters, which are the parameters ($w_1$, $w_2$, and $w_3$) defining the Warburg impedance W, are some of the first model parameters common to the parameters ($w_1$, $w_2$, and $w_3$) also defining the Warburg impedance W.

(Second battery performance evaluation)

In the target device 200, the control unit 210 in an energized state determines whether a first condition is satisfied (STEP212 of FIG. 2). As "the first condition," conditions such as that a request for battery performance evaluation of the secondary battery 220 is received in the target device 200 through the input interface 202, and that the target device 200 is connected to an external power source for charging the secondary battery 220 are adopted. The battery performance evaluation device 100 recognizes an identifier ID for distinguishing the characteristics and/or specifications of the secondary battery 220 as a target secondary battery on the basis of the communication with the target device 200 at an appropriate timing.

When it is determined that the first condition is not satisfied (NO in STEP212 of FIG. 2), then the processing for determining whether the first condition is satisfied is performed again (STEP212 of FIG. 2). The processing for determining whether the first condition is satisfied (STEP212 of FIG. 2) may be omitted.

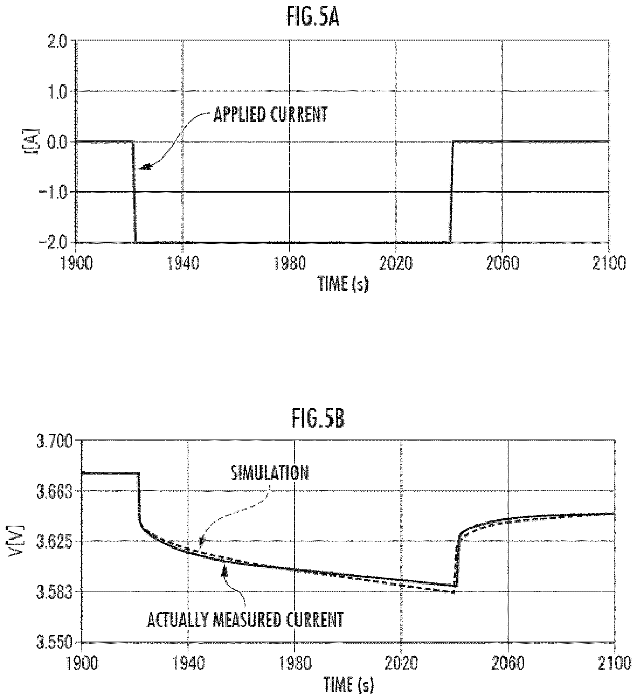

When it is determined that the first condition is satisfied (YES in STEP212 of FIG. 2), then a designated current I (t) that temporally changes in the manner illustrated in FIG. 5A is input to the secondary battery 220 as the target secondary battery (STEP214 of FIG. 2). The waveform signal of the designated current I (t) may be a waveform signal designated by the second recognition processing element 112 through mutual communication between the battery performance evaluation device 100 and the target device 200. For example, a pulse current generator installed in the target device 200 is driven by power supplied from an external power source to which the target device 200 is connected, and the designated current I (t) generated by the pulse current generator is input to the secondary battery 220. The target device 200 may be provided with an auxiliary power source for generating the designated current.

Based on an output signal of the sensor group 230, a voltage response characteristic V (t) and a temperature T of the secondary battery 220 are measured by the control unit 210 (STEP216 of FIG. 2). Thus, the voltage response characteristic V (t) of the secondary battery 220 that changes, for example, as indicated by the solid line in FIG. 5B is measured.

Subsequently, the control unit 210 determines whether a second condition is satisfied (STEP218 of FIG. 2). As "the second condition," conditions such as that sufficient waveform signals for specifying the voltage response characteristic V (t) are acquired, that a second time point is reached at which a predetermined time has elapsed from a first time point at which it was determined last that the first condition was satisfied, and that a request for battery performance evaluation of the secondary battery 220 is received through the input interface 202 in the target device 200 are adopted.

When it is determined that the second condition is not satisfied (NO in STEP218 of FIG. 2), then the processing for determining whether the first condition is satisfied is performed again (STEP212 of FIG. 2). The processing for determining whether the second condition is satisfied (STEP218 of FIG. 2) may be omitted.

When it is determined that the second condition is satisfied (YES in STEP218 of FIG. 2), then the measurement results of the voltage response characteristic V (t) and the temperature T of the secondary battery 220 are transmitted from the target device 200 to the battery performance evaluation device 100 by a transmission device constituting the output interface 204 (STEP220 of FIG. 2). Further, measurement condition information for specifying the designated current I (t) input to the secondary battery 220 when measuring the voltage response characteristic V (t) may be transmitted to the battery performance evaluation device 100 from the target device 200.

In the battery performance evaluation device 100, the measurement results of the voltage response characteristic V (t) and the temperature T of the secondary battery 220 are recognized as second measurement results by the second recognition processing element 112 (STEP 122 of FIG. 2).

The second arithmetic processing element 122 selects, among a number of secondary battery models registered in the database 10, a first battery model or a second battery model associated with an identifier ID related to the second measurement results and the measurement result of the temperature T included in the second measurement results (STEP124 of FIG. 2). When there is no first battery model for evaluating the performance of the secondary battery 220 as a target secondary battery, or when there is a second battery model, then the second battery model may be selected. When there are both the first battery model and the second battery model, then either one of the battery models (e.g., the first battery model, which exhibits slightly higher performance evaluation accuracy) may be preferentially selected.

Further, the designated current I (t) is input to the selected first battery model or second battery model by the second arithmetic processing element 122 (STEP126 of FIG. 2). The designated current I (t) may be recognized on the basis of a waveform signal designated by the second recognition processing element 112 or on the basis of the measurement condition information transmitted from the target device 200 to the battery performance evaluation device 100.

The second arithmetic processing element 122 specifies the voltage response characteristic $V_{model}$ (t) output from the first battery model or the second battery model as the output signal of the first battery model or the second battery model (STEP128 of FIG. 2). Thus, for example, the voltage response characteristic $V_{model}$ (t) of the second battery model that changes as indicated by the dashed line in FIG. 5B is specified as the output signal of the secondary battery model.

Subsequently, the battery performance evaluation element 130 evaluates the performance of the secondary battery 220 on the basis of the result of comparison between the voltage response characteristic V (t) of the secondary battery 220 as the target secondary battery and the voltage response characteristic $V_{model}$ (t) of the first battery model or the second battery model (STEP130 of FIG. 2). For example, a similarity degree x of the curves representing the voltage response characteristic V (t) of the secondary battery 220 as the target secondary battery and the voltage response characteristic $V_{model}$ (t) of the secondary battery model is specified. Then, a deterioration degree D (i) = f (x) of the secondary battery 220 is specified according to a decreasing function f with the similarity degree x as the main variable ("i" being an index meaning the type of the secondary battery 220). In other words, the higher the similarity degree x, the lower the deterioration degree D is evaluated, and conversely, the lower the similarity degree x, the higher the deterioration degree D is evaluated.

The battery performance evaluation element 130 generates deterioration diagnosis information Info (D (i)) based on the deterioration degree D (i) of the secondary battery 220 (STEP132 of FIG. 2). The battery performance evaluation element 130 transmits the diagnosis Info (D (i)) from the battery performance evaluation device 100 to the target device 200 (STEP134 of FIG. 2).

In the target device 200, the deterioration diagnosis information Info (D (i)) is received by a receiving device constituting the input interface 202 (STEP222 of FIG. 2). The deterioration diagnosis information Info (D (i)) is output to and displayed on a display device constituting the output interface 204 (STEP224 of FIG. 2). Thus, in addition to displaying a graphic display indicating the deterioration degree D (i) of the secondary battery 220, a message such as "The deterioration degree of the battery is 30%. It is recommended that the battery be replaced in 150 days." and other messages regarding measures to be taken according to the deterioration degree D (i) are displayed on the display device.

(Another embodiment of the present invention)

In the above-described embodiment, the temperature T when measuring the voltage response characteristic V (t) of each of the reference secondary battery and the target secondary battery was taken into account in selecting the first battery model and/or the second battery model to evaluate the performance of the secondary battery 220 as the target secondary battery. Meanwhile, as another embodiment, the performance of the secondary battery 220 as the target secondary battery may be evaluated by selecting the first battery model and/or the second battery model on the basis of an identifier representing the characteristics or the like of the target secondary battery without taking the temperature T into account at the time of measuring the voltage response characteristic V (t) of each of the reference secondary battery and the target secondary battery.

(Effects of the invention)

According to the battery performance evaluation device 100 in accordance with the present invention and the battery performance evaluation method performed thereby, a different battery model is determined as a battery model

**EP 4 583 245 A2**

used to evaluate the performance of a target secondary battery according to whether a designated condition is satisfied or not. To be specific, when a designated condition is satisfied, then the second battery model is determined, which is a simplified battery model defined by the second model parameters, which are fewer than those of the first battery model defined by a plurality of first model parameters (the battery model determined when a designated condition is not satisfied) (refer to YES in STEP114 → STEP118 in FIG. 2). Therefore, as compared with the case where the first battery model is established regardless of whether a designated condition is satisfied, the arithmetic processing load required for identifying the model parameters of a battery model used to evaluate the performance of the secondary battery 220 as a target secondary battery is reduced.

Description of Reference Numerals

10 .. database; 100 .. battery performance evaluation device; 111 .. first recognition processing element; 112 .. second recognition processing element; 121 .. first arithmetic processing element; 122 .. second arithmetic processing element; 130 .. battery performance evaluation element; 200 .. target device; 202 .. input interface; 204 .. output interface; 210 .. control unit; 220 .. secondary battery; 221 .. reference secondary battery; 222 .. target secondary battery; and 230 .. sensor group.

**Claims**

1. A battery performance evaluation device comprising:

   a first recognition processing element that recognizes a measurement result of an impedance of a reference secondary battery;
   a first arithmetic processing element that identifies, on the basis of a measurement result of the impedance of the reference secondary battery recognized by the first recognition processing element, a value of each of a plurality of first model parameters thereby to determine a first battery model defined by the plurality of first model parameters in the case where a designated condition is not satisfied, and identifies a value of each of a plurality of second model parameters, which are fewer than the plurality of first model parameters, thereby to determine a second battery model defined by the plurality of second model parameters in the case where the designated condition is satisfied;
   a second recognition processing element that recognizes an actually measured output voltage as a measurement result of a change form of a voltage output from a target secondary battery, which has the same characteristics as those of the reference secondary battery, at the time of input of a designated current to the target secondary battery;
   a second arithmetic processing element that specifies a model output voltage as a change form of a voltage output from the first battery model or the second battery model at the time of input of the designated current to the first battery model or the second battery model determined by the first arithmetic processing element; and
   a battery performance evaluation element that evaluates performance of the target secondary battery on the basis of a result of comparison between the actually measured output voltage recognized by the second recognition processing element and the model output voltage specified by the second arithmetic processing element, wherein
   each of the plurality of first model parameters and the plurality of second model parameters include a parameter defining a Warburg impedance, and wherein
   a parameter which is part of the plurality of second model parameters and which defines the Warburg impedance, is common to a parameter which is part of the plurality of first model parameters and which defines the Warburg impedance.

2. The battery performance evaluation device according to claim 1,

   wherein the first recognition processing element recognizes a measurement result of an impedance at each of different temperatures of the reference secondary battery,
   the first arithmetic processing element determines the first battery model by specifying temperature dependence of a value of each of the plurality of first model parameters on the basis of the measurement result of the impedance at each of the different temperatures of the reference secondary battery recognized by the first recognition processing element in the case where the designated condition is not satisfied, and determines the second battery model by specifying temperature dependence of a value of each of the plurality of second model parameters in the case where the designated condition is satisfied,

9

the second recognition processing element recognizes a measurement result of a temperature of the target secondary battery in addition to the output voltage of the target secondary battery, and

the second arithmetic processing element specifies the model output voltage at the time of inputting, to the first battery model or the second battery model determined by the first arithmetic processing element, the measurement result of the temperature of the target secondary battery recognized by the second recognition processing element in addition to the designated current.

3. The battery performance evaluation device according to claim 1 or 2,
wherein the first arithmetic processing element establishes the first battery model or the second battery model on the basis of at least one of the designated conditions including a condition that the designated current is composed of a low frequency current component that is lower than a reference frequency, and a condition that an arithmetic processing load of the first arithmetic processing element is a reference value or more.

4. A battery performance evaluation method comprising:

a first recognition processing step of recognizing a measurement result of an impedance of a reference secondary battery;

a first arithmetic processing step of identifying, on the basis of a measurement result of the impedance of the reference secondary battery recognized in the first recognition processing step, a value of each of a plurality of first model parameters thereby to determine a first battery model defined by the plurality of first model parameters in the case where a designated condition is not satisfied, and identifying a value of each of a plurality of second model parameters, which are fewer than the plurality of first model parameters, thereby to determine a second battery model defined by the plurality of second model parameters in the case where the designated condition is satisfied;

a second recognition processing step of recognizing an actually measured output voltage as a measurement result of a change form of a voltage output from a target secondary battery, which has the same characteristics as those of the reference secondary battery, at the time of input of a designated current to the target secondary battery;

a second arithmetic processing step of specifying a model output voltage as a change form of a voltage output from the first battery model or the second battery model at the time of input of the designated current to the first battery model or the second battery model determined in the first arithmetic processing step; and

a battery performance evaluation step of evaluating performance of the target secondary battery on the basis of a result of comparison between the actually measured output voltage recognized in the second recognition processing step and the model output voltage specified in the second arithmetic processing step, wherein

each of the plurality of first model parameters and the plurality of second model parameters include a parameter defining a Warburg impedance, and wherein

a parameter which is part of the plurality of second model parameters and which defines the Warburg impedance, is common to a parameter which is part of the plurality of first model parameters and which defines the Warburg impedance.

FIG. 1

FIG.2

**PERFORMANCE EVALUATION DEVICE 100**

(10)

STEP112
RECOGNIZE FIRST MEASUREMENT RESULT

STEP114
SATISFY DESIGNATED CONDITION?
— NO → STEP 116
— YES → STEP 118

STEP 116
IDENTIFY FIRST MODEL PARAMETERS AND ESTABLISH FIRST BATTERY MODEL

STEP 118
IDENTIFY SECOND MODEL PARAMETERS AND ESTABLISH SECOND BATTERY MODEL

(11)

STEP122
RECOGNIZE SECOND MEASUREMENT RESULT

STEP124
SELECT BATTERY MODEL BASED ON TEMPERATURE T

STEP126
INPUT IMPULSE CURRENT TO BATTERY MODEL

STEP128
RECOGNIZE VOLTAGE RESPONSE CHARACTERISTIC OF BATTERY MODEL

STEP130
EVALUATE DETERIORATION STATE D(i)

STEP132
GENERATE PERFORMANCE EVALUATION INFORMATION Info (D(i))

STEP134
TRANSMIT PERFORMANCE EVALUATION INFORMATION Info (D(i))

(22)

**TARGET DEVICE 200**

(21)

STEP212
SATISFY FIRST CONDITION? — NO

YES
STEP214
INPUT DESIGNATED CURRENT TO SECONDARY BATTERY

STEP216
MEASURE VOLTAGE RESPONSE CHARACTERISTIC V(t) AND TEMPERATURE T OF SECONDARY BATTERY

STEP218
SATISFY SECOND CONDITION? — NO

YES
STEP220
TRANSMIT SECOND MEASUREMENT RESULT

(11)

(22)

STEP222
RECEIVE PERFORMANCE EVALUATION INFORMATION Info (D(i))

STEP224
OUTPUT PERFORMANCE EVALUATION INFORMATION Info (D(i))

(21)

(21)

EP 4 583 245 A2

## FIG.3A

## FIG.3B

# FIG.4A

## FIG.4B

## FIG.5A

## FIG.5B

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 6745554 B

- JP 6842212 B